(19) Europäisches Patentamt
European Patent Office
Office européen des brevets

(11) **EP 4 107 534 B1**

(12) **EUROPÄISCHE PATENTSCHRIFT**

(45) Veröffentlichungstag und Bekanntmachung des Hinweises auf die Patenterteilung:
**29.01.2025 Patentblatt 2025/05**

(21) Anmeldenummer: **21705512.8**

(22) Anmeldetag: **15.02.2021**

(51) Internationale Patentklassifikation (IPC):
**G01R 31/08** (2020.01)   **G01R 31/34** (2020.01)

(52) Gemeinsame Patentklassifikation (CPC):
**G01R 31/08; G01R 31/088; G01R 31/346**

(86) Internationale Anmeldenummer:
**PCT/EP2021/053644**

(87) Internationale Veröffentlichungsnummer:
**WO 2021/165202 (26.08.2021 Gazette 2021/34)**

(54) **VORRICHTUNG UND VERFAHREN ZUM LOKALISIEREN VON TEILENTLADUNGEN IN MITTEL- UND HOCHSPANNUNGSBETRIEBSMITTELN**

APPARATUS AND METHOD FOR LOCATING PARTIAL DISCHARGES IN MEDIUM-VOLTAGE AND HIGH-VOLTAGE EQUIPMENT

APPAREIL ET PROCÉDÉ DE LOCALISATION DE DÉCHARGES PARTIELLES DANS UN ÉQUIPEMENT À MOYENNE TENSION ET HAUTE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.02.2020 AT 501152020**

(43) Veröffentlichungstag der Anmeldung:
**28.12.2022 Patentblatt 2022/52**

(73) Patentinhaber: Omicron electronics GmbH
**6833 Klaus (AT)**

(72) Erfinder:
• **ENGELEN, Christoph**
**52076 Aachen (DE)**

• **ÖTTL, Fabian**
**6800 Feldkirch (AT)**

(74) Vertreter: **Kraus & Lederer PartGmbB**
**Thomas-Wimmer-Ring 15**
**80539 München (DE)**

(56) Entgegenhaltungen:
**EP-A1- 2 360 486**

• **LUO YUANLIN ET AL: "A Review of Online Partial Discharge Measurement of Large Generators", ENERGIES, vol. 10, no. 11, 25 October 2017 (2017-10-25), pages 1694, XP055804886, DOI: 10.3390/en10111694**

EP 4 107 534 B1

**Beschreibung**

Die vorliegende Erfindung betrifft Vorrichtungen und Verfahren zum Lokalisieren von Teilentladungen in Mittel- oder Hochspannungsbetriebsmitteln. Insbesondere betrifft die vorliegende Erfindung derartige Vorrichtungen und Verfahren, die zum Lokalisieren von Teilentladungen in Mittel- oder Hochspannungsbetriebsmitteln mit komplexen Wicklungsstrukturen einsetzbar sind.

HINTERGRUND DER ERFINDUNG

Mittel- oder Hochspannungsbetriebsmittel können bei Beschädigung ihrer Leiterisolierung kurzschlussbedingt ausfallen. Erste Anzeichen dieser Beschädigungen zeigen sich oft durch Teilentladungsmessung. Neben dem der Fragestellung, ob Teilentladungen (TE) aktiv sind, ist eine Lokalisierung des Entstehungsorts der TE entscheidend.

Je nach Betriebsmittel existieren verschiedene Verfahren, um eine TE zu lokalisieren.

Elektromagnetische Verfahren tasten beispielsweise eine Wicklung mit Hilfe eines Sensors, etwa einer Spule mit Ferritkern, ab und erfassen einen Ausschlag einer TE-bedingten Spannung im mV-Bereich. Ferner ist es in Energiekabeln möglich, TE-bedingte elektrische Impulse einer Signalausbreitungszeitanalyse zu unterziehen. Andere elektromagnetische Verfahren analysieren TE-bedingte Funkwellen.

Akustische Verfahren tasten eine Wicklung, und insbesondere einen Wickelkopf, mit Hilfe von Schallmessungen ab. Dabei sind oberflächennahe Erscheinungen besser detektierbar als Defekte in der Wicklung. Beispielsweise kann eine Triangulation akustischer Signale in ölgefüllten Betriebsmitteln erfolgen.

Optische Verfahren unterziehen eine Wicklung einer Lichtmessung, da TE neben Geräuschen auch Licht emittieren, welches mit entsprechenden Filtern vom Tageslicht getrennt werden kann. Hierbei werden nur Oberflächenerscheinungen erkannt.

Hinsichtlich rotierender elektrischer Maschinen lassen sich diese Verfahren jedoch nicht anwenden: Aufgrund der komplexen Wicklungsstruktur ergeben sich parallele Ausbreitungspfade für elektrische Impulse, wodurch eine Signalausbreitungszeitanalyse nicht durchgeführt werden kann. Eine akustische Ortung ist bedingt durch die Feststoffisolation und die mangelnde Zugänglichkeit der Wicklung ebenfalls nicht einsetzbar.

Den bekannten Verfahren ist gemein, dass es keine Zuordnung der TE zum elektrisch gemessenen Impuls an den Anschlüssen und deshalb keine Zuordnung zu der scheinbaren Ladung gibt (vgl. phasenaufgelöste TE, engl. PRPD). Letztere wäre erforderlich für eine belastbare Aussage, wie energiereich die Teilentladung an ihrem Entstehungsort sein kann. Ferner steigt der Aufwand hinsichtlich Sensorik und Messaufwand, da eine Reihe von Messungen durchgeführt werden muss, um den Entstehungsort der TE bestimmen zu können.

Ferner muss ggf. die Wicklung zugänglich gemacht werden, was den Messaufwand nochmals deutlich erhöht.

Eine Vorrichtung zum Lokalisieren einer Teilentladung in einem Mittel- oder Hochspannungsbetriebsmittel gemäß dem Oberbegriff des Anspruchs 1 und ein entsprechendes Verfahren gemäß dem Oberbegriff des Anspruchs 10 sind aus der Druckschrift EP 2 360 486 A1 bekannt.

Des Weiteren ist aus der Druckschrift "A Review of Online Partial Discharge Measurement of Large Generators", Luo Yuanlin et al, ENERGIES, Bd. 10, Nr. 11, 25. Oktober 2017, Seite 1694, XP055804886 im Zusammenhang mit der Lokalisierung von Teilentladungen für ein Windungssystem wie einen Generator oder Motor bekannt, dass es für Teilentladungen zwei verschiedene Ausbreitungsmodi gibt, nämlich einen langsamen kabelgebundenen Ausbreitungsmodus niedrigerer Frequenz entlang des vorgesehenen Leitungspfads und einen schnellen Ausbreitungsmodus höherer Frequenz außerhalb des vorgesehenen Leitungspfads.

ZUSAMMENFASSUNG DER ERFINDUNG

Es besteht ein Bedarf an verbesserten Vorrichtungen und Verfahren zum Lokalisieren/Orten von Teilentladungen in Mittel- oder Hochspannungsbetriebsmitteln, insbesondere in Betriebsmitteln mit komplexen Wicklungsanordnung (z.B. elektrische rotierende Maschinen).

Diese Aufgabe wird durch die Merkmale der unabhängigen Patentansprüche gelöst. Die Merkmale der abhängigen Patentansprüche definieren bevorzugte oder vorteilhafte Ausführungsformen.

Ein erster Aspekt der Erfindung betrifft eine Vorrichtung zum Lokalisieren von Teilentladungen in Mittel- oder Hochspannungsbetriebsmitteln. Die Vorrichtung umfasst eine Signalerfassungseinrichtung zum Erfassen einer elektrischen Signalgröße des Betriebsmittels; eine Filtereinrichtung zum Tiefpassfiltern der erfassten elektrischen Signalgröße in Abhängigkeit von einer Filtergrenzfrequenz; eine Zeiterfassungseinrichtung zum Erfassen einer Signalausbreitungszeit der tiefpassgefilterten elektrischen Signalgröße; und eine Vergleichseinrichtung zum Vergleichen der in Abhängigkeit von der Filtergrenzfrequenz erfassten Signalausbreitungszeit mit einer Referenzausbreitungszeit für leitungsgebunden durch das Betriebsmittel geleitete Ladungsimpulse. Auf Grundlage dieses Vergleichs kann schließlich der Ort der jeweiligen Teilentladung in dem Betriebsmittel bestimmt werden.

Die Filtereinrichtung ist zum von einer anfänglichen Filtergrenzfrequenz ausgehenden, schrittweisen Reduzieren der Filtergrenzfrequenz eingerichtet, bis eine bei der reduzierten Filtergrenzfrequenz erfasste Signalausbreitungszeit einen vorgegebenen absoluten Signalausbreitungszeitschwellwert übersteigt oder eine bei der anfänglichen Filtergrenzfrequenz erfasste Signalausbreitungszeitdauer um ein vorgegebenes relatives Signalausbreitungszeitverhältnis übersteigt.

Eine Schrittweite beim Reduzieren der Filtergrenzfrequenz kann mindestens 0.1 kHz, bevorzugt 1 kHz und weiter bevorzugt 10 kHz betragen.

Das vorgegebene relative Signalausbreitungszeitverhältnis kann mindestens 2, bevorzugt 5 und besonders bevorzugt 10 betragen.

Die Filtergrenzfrequenz kann höchstens 1 MHz, bevorzugt höchstens 100 kHz, und besonders bevorzugt höchstens 50 kHz betragen.

Die Vorrichtung kann ferner einen Ladungskalibrator zum leitungsgebundenen Leiten eines Ladungsimpulses durch das Betriebsmittel umfassen, um für diesen Ladungsimpuls die Referenzausbreitungszeit zu bestimmen.

Die Erfindung kann vorzugsweise digital implementiert sein. Die erfasste elektrische Signalgröße kann demzufolge digitale Spannungswerte umfassen, und die Signalerfassungseinrichtung kann einen digitale Spannungswerte bereitstellenden Spannungsmesser umfassen. Die Filtereinrichtung kann ein digitales Tiefpassfilter umfassen. Die Zeiterfassungseinrichtung kann einen digitale Zeitwerte bereitstellenden Zeitmesser umfassen. Die Vergleichseinrichtung kann eine ein Vergleichsergebnis der erfassten Signalausbreitungszeit mit der Referenzausbreitungszeit bereitstellende Arithmetikoder Recheneinheit umfassen.

Ein zweiter Aspekt der Erfindung betrifft ein Verfahren zum Lokalisieren von Teilentladungen in Mittel- oder Hochspannungsbetriebsmitteln. Das Verfahren umfasst ein Erfassen einer elektrischen Signalgröße des Betriebsmittels; ein Tiefpassfiltern der erfassten elektrischen Signalgröße in Abhängigkeit von einer Filtergrenzfrequenz; ein Erfassen einer Signalausbreitungszeit der tiefpassgefilterten elektrischen Signalgröße; und ein Vergleichen der in Abhängigkeit von der Filtergrenzfrequenz erfassten Signalausbreitungszeit mit einer Referenzausbreitungszeit für leitungsgebunden durch das gesamte Betriebsmittel geleitete Ladungsimpulse.

Das Verfahren umfasst ferner ein von einer anfänglichen Filtergrenzfrequenz ausgehendes, schrittweises Reduzieren der Filtergrenzfrequenz, bis eine bei der reduzierten Filtergrenzfrequenz erfasste Signalausbreitungszeit einen vorgegebenen absoluten Signalausbreitungszeitschwellwert übersteigt oder eine bei der anfänglichen Filtergrenzfrequenz erfasste Signalausbreitungszeitdauer um ein vorgegebenes relatives Signalausbreitungszeitverhältnis übersteigt.

Das Verfahren kann ferner vor Lokalisierung der Teilentladung ein leitungsgebundenes Leiten eines Ladungsimpulses durch Betriebsmittel oder entlang des Betriebsmittels zum Bestimmen der Referenzausbreitungszeit umfassen.

Das Verfahren kann zudem umfassen, dass ein Frequenzbereich der elektrischen Signalgröße, in dem eine niederfrequente Komponente der Teilentladung gegenüber einer hochfrequenten Komponente der Teilentladung dominiert, bestimmt wird. In dem erfassten Frequenzbereich wird die Signalausbreitungszeit der elektrischen Signalgröße bestimmt und mit der Referenzausbreitungszeit verglichen, um in Abhängigkeit von dem Vergleichsergebnis den Ort der Teilentladung in dem Betriebsmittel zu bestimmen.

Allgemein kann das erfindungsgemäße Verfahren mit der erfindungsgemäßen Vorrichtung nach einem der hierin beschriebenen Ausführungsformen automatisiert bzw. rechnergestützt durchgeführt werden.

KURZE BESCHREIBUNG DER FIGUREN

Die Erfindung wird nachfolgend anhand bevorzugter Ausführungsformen und unter Bezugnahme auf die Zeichnungen kurz erläutert, wobei gleiche Bezugszeichen gleiche oder ähnliche Elemente bezeichnen.

Fig. 1 veranschaulicht eine Vorrichtung zum Lokalisieren von Teilentladungen in Mittel- oder Hochspannungsbetriebsmitteln nach einem Ausführungsbeispiel.

Fig. 2 veranschaulicht eine Abhängigkeit eines Amplitudenganges einer Filtereinrichtung zum Tiefpassfiltern einer erfassten elektrischen Signalgröße von einer Filtergrenzfrequenz.

Fig. 3 veranschaulicht eine Abhängigkeit einer Signalausbreitungszeit einer Teilentladung in dem Betriebsmittel von der Filtergrenzfrequenz.

Fig. 4 veranschaulicht ein Verfahren zum Lokalisieren von Teilentladungen in Mittel- oder Hochspannungsbetriebsmitteln nach einem Ausführungsbeispiel.

DETAILLIERTE BESCHREIBUNG VON AUSFÜHRUNGSBEISPIELEN

Die Erfindung wird nachfolgend anhand bevorzugter Ausführungsformen und unter Bezugnahme auf die Zeichnungen näher erläutert.

Eine Beschreibung von Ausführungsbeispielen in spezifischen Anwendungsfeldern bedeutet keine Einschränkung auf diese Anwendungsfelder.

Elemente schematischer Darstellungen sind nicht notwendigerweise maßstabsgetreu wiedergegeben, sondern vielmehr derart, dass Fachleuten ihre Funktion und ihr Zweck verständlich werden.

Soweit nicht ausdrücklich anders angegeben sind die Merkmale der verschiedenen Ausführungsformen miteinander kombinierbar.

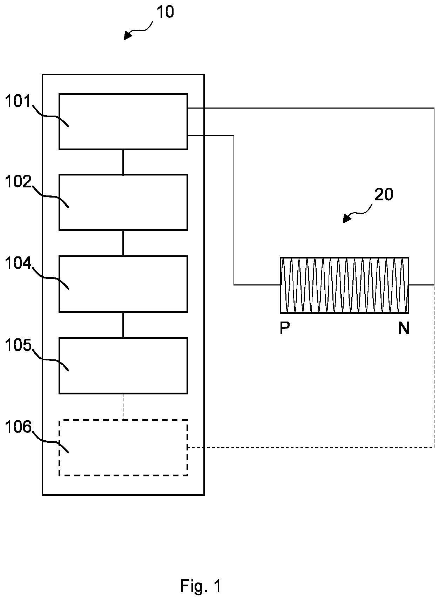

Fig. 1 veranschaulicht eine Vorrichtung 10 zum Lokalisieren von Teilentladungen in Mittel- oder Hochspannungsbetriebsmitteln 20 nach einem Ausführungsbeispiel.

Unter einem Mittel- bzw. Hochspannungsbetriebsmittel im Sinne dieser Anmeldung können Betriebsmittel verstanden werden, welche auf den Spannungsniveaus des Hochspannungsnetzes oder des Mittelspannungsnetzes einsetzbar sind. Diese können insbesondere komplexe Wicklungsstrukturen aufweisen. Beispiele hierfür umfassen etwa elektrische rotierende Maschinen, Leistungstransformatoren und Spannungswandler. Ebenso ist die Erfindung auch für Maschinen in Industrieanwendungen einsetzbar.

Unter einer Teilentladung oder Vorentladung im Sinne dieser Anmeldung können vor allem bei Beanspruchung mit Wechselspannungen örtlich auftretende, unvollkommene elektrische Durchschläge einer Isolierung von Leiterstrukturen in Mittel- oder Hochspannungsbetriebsmitteln verstanden werden.

Die in Fig. 1 auf der linken Seite abgebildete Vorrichtung 10 umfasst eine Signalerfassungseinrichtung 101 zum Erfassen 301 einer elektrischen Signalgröße des in Fig. 1 auf der rechten Seite abgebildeten Betriebsmittels 20. Wie Fig. 1 veranschaulicht sind die aus dem Betriebsmittel 20 herausgeführten und in Fig. 1 mit "P(hase)" und "N(eu-tral)" bezeichneten Anschlüsse des Betriebsmittels 20 elektrisch leitend an die Signalerfassungseinrichtung 101 anschließbar.

Unter einer elektrischen Signalgröße im Sinne dieser Anmeldung können eine elektrische Stromstärke oder insbesondere eine elektrische Spannung (Potentialdifferenz) verstanden werden.

Die Signalerfassungseinrichtung 101 kann einen digitale Spannungswerte bereitstellenden Spannungsmesser umfassen, und die erfasste elektrische Signalgröße kann demzufolge digitale Spannungswerte umfassen.

Dies vereinfacht einen Schaltungsaufwand und eine nachfolgende Signalverarbeitung erheblich.

Die Vorrichtung 10 umfasst ferner eine Filtereinrichtung 102 zum Tiefpassfiltern 302 der erfassten elektrischen Signalgröße in Abhängigkeit von einer Filtergrenzfrequenz $fc$.

Unter einer Filtergrenzfrequenz, Knickfrequenz oder Eckfrequenz im Sinne dieser Anmeldung können jene Frequenzen verstanden werden, bei welchen ein Amplitudengang einer gefilterten elektrischen Signalgröße auf einen Wert von $1/\sqrt{2} \approx 70{,}7\%$ absinkt.

Unter einem Amplitudengang im Sinne dieser Anmeldung kann ein frequenzabhängiges Verhältnis zwischen den Amplituden einer Eingangsgröße und einer Ausgangsgröße eines linearen zeitinvarianten Systems, insbesondere eines Filters, bei sinusförmiger Anregung verstanden werden.

Eine Signalausbreitung TE-bedingter elektromagnetischer Signale/Impulse erfolgt in Abhängigkeit ihrer Frequenz. Dabei können die Signale durch die Isolierung (hochfrequent) oder leitungsgebunden durch die Kupferbahnen (niederfrequent) übertragen werden. Hochfrequente Anteile werden also abgestrahlt, sind leitungsungebunden und treffen auf kürzestem Weg an der Signalerfassungseinrichtung 101 ein. Niederfrequente Anteile sind dagegen leitungsgebunden und folgen der Wicklungsgeometrie.

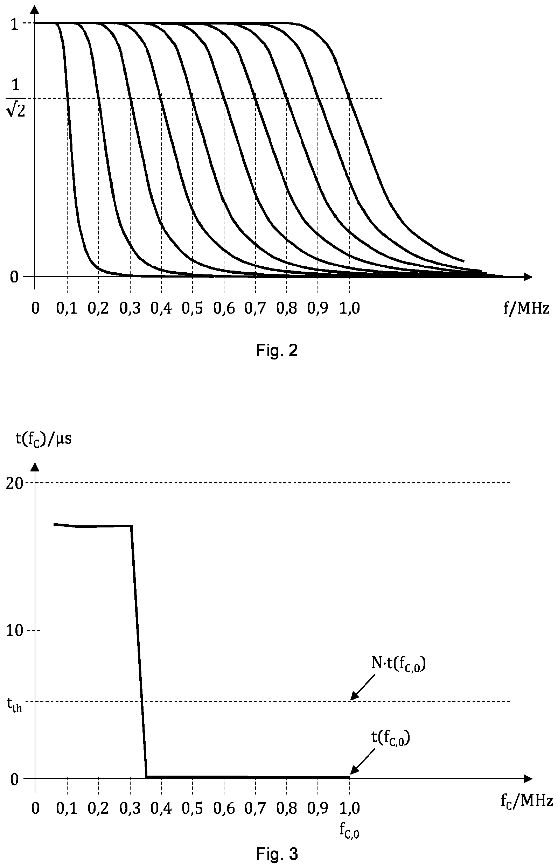

Fig. 2 veranschaulicht eine Abhängigkeit eines Amplitudenganges einer Filtereinrichtung 102 zum Tiefpassfiltern 302 einer erfassten elektrischen Signalgröße von einer Filtergrenzfrequenz fc.

Das Tiefpassfiltern 302 entfernt die hochfrequenten Anteile, wie Fig. 2 beispielhaft veranschaulicht. Dargestellt ist der Amplitudengang derselben Filtereinrichtung 102 bei zehn verschiedenen Filtergrenzfrequenzen fc von 0,1 MHz bis 1 MHz. In einem jeweiligen Durchlassbereich liegt der Amplitudengang der gefilterten elektrischen Signalgröße über dem Wert von $1/\sqrt{2} \approx 70{,}7\%$ , der die jeweilige Filtergrenzfrequenz fc kennzeichnet, und in einem Sperrbereich darunter.

Ein schrittweises Reduzieren 303 der Filtergrenzfrequenz fc hat demnach zur Folge, dass sich der Durchlassbereich bei niedrigeren Frequenzen sukzessive verringert und der Sperrbereich bei höheren Frequenzen sukzessive vergrößert.

Fig. 3 veranschaulicht eine Abhängigkeit einer Signalausbreitungszeit t(fc) von der Filtergrenzfrequenz fc. Dargestellt ist die beispielhafte Signalausbreitungszeit t(fc) eines TE-bedingten elektromagnetischen Impulses bis zur Signalerfassungseinrichtung 101 in Abhängigkeit von einer sukzessive von 1 MHz bis etwa 0,1 MHz reduzierten 303 Filtergrenzfrequenz fc.

Je nach Filtergrenzfrequenz fc kann zunächst die hochfrequente Komponente des Signals dominieren, wie Fig. 3 beispielhaft veranschaulicht. Diese breitet sich durch Abstrahlung aus und trifft auf kürzestem Weg bei der Signalerfassungseinrichtung 101 ein.

Die Filtereinrichtung 102 kann zu einem von einer anfänglichen Filtergrenzfrequenz $f_{C,0}$ ausgehenden, schrittweisen Reduzieren 303 der Filtergrenzfrequenz $f_c$ eingerichtet sein, bis eine bei der reduzierten Filtergrenzfrequenz $f_c$ erfasste Signalausbreitungszeit $t$ einen vorgegebenen absoluten Signalausbreitungszeitschwellwert $trn$ übersteigt oder eine bei der anfänglichen Filtergrenzfrequenz $f_{C,0}$ erfasste Signalausbreitungszeitdauer $t_0$ um ein vorgegebenes relatives Signalausbreitungszeitverhältnis $N$ übersteigt.

Bei schrittweisem Reduzieren 303 der Filtergrenzfrequenz fc zeigt sich bei etwa 0,35 MHz ein sprunghafter Anstieg der Signalausbreitungszeit t. Dieser Sprung wird als Übergang betrachtet, bei dem die niederfrequente, leitungsgebundene Komponente der erfassten elektrischen Signalgröße dominiert, und variiert je nach Prüfobjekt und wurde insbesondere im Bereich < 1 MHz beobachtet. Das schrittweise Reduzieren 303 kann auch bis in den unteren MHz-Bereich (z.B. < 10 kHz) ausgedehnt werden. Die aussagekräftigsten Ergebnisse werden bei Filterfrequenzen von < 100 kHz, noch besser 10 - 50 kHz, erzielt.

Bei Kenntnis der Filtergrenzfrequenz $f_C$ eines Prüfobjekts, bei der eine niederfrequente, leitungsgebundene Signalausbreitung dominiert, kann diese direkt eingestellt oder konfiguriert werden, ohne ein schrittweises Reduzieren 303 der Filtergrenzfrequenz $f_C$ im Feld zu erfordern. Mit dem schrittweisen Reduzieren 303 der Filtergrenzfrequenz $f_C$ erübrigt sich demzufolge eine Datenhaltung für prüfobjektspezifische Filtergrenzfrequenzen $f_C$ und ergibt sich eine Automatisierung des Prüfvorgangs.

Durch das Tiefpassfiltern 302 wird die Mehrwegeausbreitung der Signale durch die Isolierung eliminiert, wodurch anschließend eine Laufzeitanalyse durchgeführt werden kann, wie sie von Energiekabeln bekannt ist. Bei Kenntnis von Wicklungsgeometrie und Gesamtlaufzeit durch die Wicklung kann so einen Rückschluss auf den Entstehungsort der TE erfolgen.

Die Filtereinrichtung 102 kann insbesondere ein digitales Tiefpassfilter umfassen.

Dies vereinfacht den Schaltungsaufwand und die nachfolgende Signalverarbeitung erheblich, insbesondere im Hinblick auf eine Einstellbarkeit der Filtergrenzfrequenz fc.

Die Vorrichtung 10 umfasst ferner eine Zeiterfassungseinrichtung 104 zum Erfassen 304 einer Signalausbreitungszeit t der tiefpassgefilterten elektrischen Signalgröße. Die Zeiterfassungseinrichtung 103 kann einen digitale Zeitwerte bereitstellenden Zeitmesser umfassen.

Dies vereinfacht den Schaltungsaufwand und die nachfolgende Signalverarbeitung erheblich, insbesondere im Hinblick auf einer ggf. erforderlichen Speicherung und Verarbeitung einer Anzahl von Signalausbreitungszeitdauern für eine entsprechende Anzahl von verschiedenen Filtergrenzfrequenzen $f_C$.

Die Vorrichtung 10 umfasst ferner eine Vergleichseinrichtung 105 zum Vergleichen 305 der in Abhängigkeit von der Filtergrenzfrequenz $f_C$ erfassten Signalausbreitungszeit $t(f_C)$ mit einer Referenzausbreitungszeit $t_{ref}$ für leitungsgebunden durch das gesamte Betriebsmittel 20 geleitete Ladungsimpulse.

Die Vergleichseinrichtung 105 kann eine ein Vergleichsergebnis der erfassten Signalausbreitungszeit $t$ mit der Referenzausbreitungszeit $t_{ref}$ bereitstellende Arithmetikeinheit umfassen.

Die Referenzausbreitungszeit $t_{ref}$ für leitungsgebunden durch das gesamte Betriebsmittel 20 geleitete Ladungsimpulse kann beispielsweise bei Fertigung oder vor Inbetriebnahme des Betriebsmittels 20 unter Zuhilfenahme eines Ladungskalibrators 106 (s.u.) erfasst werden. Dabei wird ein künstlich erzeugter Ladungsimpuls durch das gesamte Betriebsmittel 20 geleitet. Die dadurch ermittelte Referenzausbreitungszeit $t_{ref}$ entspricht einer Gesamtlänge $L$ des leitungsgebundenen Signalausbreitungspfads zwischen den Anschlüssen des Betriebsmittels 20. Eine Teilentladung in dem Betriebsmittel 20 tritt zwischen diesen Anschlüssen auf. Die in Abhängigkeit von der Filtergrenzfrequenz $f_C$ erfasste leitungsgebundene Signalausbreitungszeit $t(f_C)$ ist stets ein Bruchteil der Referenzausbreitungszeit $t_{ref}$ und entspricht einem gleichen Bruchteil der Länge L des gesamten Signalausbreitungspfads:

$$\frac{x}{L} = \frac{t(fc)}{t_{ref}}$$

Durch das Vergleichen 305 der beiden Signalausbreitungszeiten lassen sich also Teilentladungen in einer Wicklung des Betriebsmittels 20 an einer Längenposition $x$ zwischen den Anschlüssen des Betriebsmittels 20 lokalisieren, ohne über einen direkten Zugang zu der betreffenden Wicklung des Betriebsmittels 20 zu verfügen, da die zugrundeliegenden Messungen an den Anschlüssen des Betriebsmittels 20 vorgenommen werden können. Bei zusätzlicher Kenntnis der komplexen Wicklungsgeometrie des Betriebsmittels 20 lässt sich ferner eine exakte räumliche Lokalisierung des Entstehungsorts der TE vornehmen.

Die Vorrichtung 10 kann ferner einen Ladungskalibrator 106 zum leitungsgebundenen Leiten 306 eines Ladungsimpulses durch das gesamte Betriebsmittel 20 umfassen.

Der eigentlichen TE-Messung vorausgehend, und daher in Fig. 1 durch Strichmuster als optional angedeutet, kann mit einem Ladungskalibrator 106 ein künstlich erzeugter TE-Impuls durch die gesamte Wicklung geschickt werden. Der Ladungskalibrator 106 ist hierzu elektrisch leitend an dem fernen "N(eutral)"-Anschluss des Betriebsmittels 20 anzuschließen. Der dort durch den Ladungskalibrator 106 freigesetzte Ladungsimpuls pflanzt sich von dem fernen "N(eutral)"-Anschluss durch die gesamte zwischen den Anschlüssen des Betriebsmittels 20 vorgesehene Wicklung zum der Signalerfassungseinrichtung 101 nahen "P(hasen)"-Anschluss hin fort und führt nach einer Laufzeit $t_{ref}$ zu einer Änderung der dort erfassten 301 elektrischen Signalgröße. Die Laufzeit $t_{ref}$ dieses Impulses dient als Referenz für die Laufzeit, die ein Impuls benötigt, um die gesamte Wicklung zu durchlaufen (Gesamtlaufzeit). Die Laufzeit t eines realen TE-Impulses wird relativ zu dieser Referenz angegeben, um die relative Position des Entstehungsorts der TE innerhalb der Wicklung anzugeben. Selbstverständlich kann der Ladungskalibrator 106 alternativ auch an den "P(hasen)"-Anschluss angeschlossen sein, während die Signalerfassung dann über den "N(eutral)"-Anschluss erfolgt.

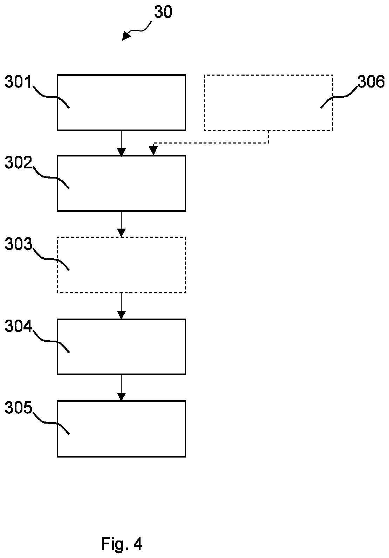

Fig. 4 veranschaulicht ein Verfahren 30 zum Lokalisieren von Teilentladungen in Mittel- oder Hochspannungsbetriebsmitteln 20 nach einem Ausführungsbeispiel.

Das Verfahren 30 kann mit der Vorrichtung 10 nach verschiedenen Ausführungsbeispielen durchgeführt werden.

Demzufolge sind die oben genannten Vorrichtungsmerkmale und deren Vorteile in dem Verfahren analog nutzbar.

Hierzu ist die Signalerfassungseinrichtung 101 der Vorrichtung 10 wie in Fig. 1 gezeigt elektrisch leitend mit den nahen und fernen Anschlüssen des Betriebsmittels 20 zu verbinden.

In Schritt 301 umfasst das Verfahren 30 ein Erfassen einer elektrischen Signalgröße des Betriebsmittels 20 mittels der Signalerfassungseinrichtung 101 der Vorrichtung 10.

In Schritt 302 umfasst das Verfahren 30 ein Tiefpassfiltern der erfassten elektrischen Signalgröße mittels einer Filtereinrichtung 102 der Vorrichtung 10 in Abhängigkeit von einer Filtergrenzfrequenz $f_C$ der Filtereinrichtung 102.

Die Filtergrenzfrequenz $f_C$ kann höchstens 1 MHz, bevorzugt höchstens 100 kHz, und stärker bevorzugt höchstens 50 kHz betragen.

In Schritt 303 kann das Verfahren 30 ferner ein von einer anfänglichen Filtergrenzfrequenz $f_{C,0}$ ausgehendes, schrittweises Reduzieren der Filtergrenzfrequenz fc umfassen, bis eine bei der reduzierten Filtergrenzfrequenz $f_C$ erfasste Signalausbreitungszeit t einen vorgegebenen absoluten Signalausbreitungszeitschwellwert $t_{th}$ übersteigt oder eine bei der anfänglichen Filtergrenzfrequenz $f_{C,0}$ erfasste Signalausbreitungszeitdauer $t_0$ um ein vorgegebenes relatives Signalausbreitungszeitverhältnis N übersteigt.

$$t(f_C) > t_{th} \text{ oder } t(f_C) > N \cdot t(f_{C,0})$$

Eine Schrittweite beim Reduzieren 303 der Filtergrenzfrequenz $f_C$ kann mindestens 0.1 kHz, bevorzugt 1 kHz und noch stärker bevorzugt 10 kHz betragen.

Dies begrenzt eine Dauer einer TE-Untersuchung eines Prüfobjekts.

Das vorgegebene relative Signalausbreitungszeitverhältnis N kann mindestens 2, bevorzugt 5 und besonders bevorzugt 10 betragen.

Dies ermöglicht zusätzlich oder alternativ eine relative Festlegung eines Schwellwerts zur Erkennung eines sprunghaften Anstiegs der Signalausbreitungszeit t beim schrittweisen Reduzieren 303 der Filtergrenzfrequenz $f_C$.

In Schritt 304 umfasst das Verfahren 30 ein Erfassen einer Signalausbreitungszeit t der tiefpassgefilterten elektrischen Signalgröße mittels einer Zeiterfassungseinrichtung 104 der Vorrichtung 10.

In Schritt 305 umfasst das Verfahren 30 ein Vergleichen der in Abhängigkeit von der Filtergrenzfrequenz $f_C$ erfassten Signalausbreitungszeit t mit einer Referenzausbreitungszeit $t_{ref}$ für leitungsgebunden durch das gesamte Betriebsmittel 20 geleitete Ladungsimpulse mittels einer Vergleichseinrichtung 105.

Das Verfahren 30 kann in Schritt 306 ferner ein leitungsgebundenes Leiten eines Ladungsimpulses durch das gesamte Betriebsmittel 20 mittels eines Ladungskalibrators 106 der Vorrichtung 10 umfassen, wobei der Schritt 306 in Fig. 4 und der Ladungskalibrator 106 in Fig. 1 durch Strichmuster als optional angedeutet sind. Der Ladungskalibrator 106 ist elektrisch leitend mit dem fernen Anschluss des Betriebsmittels 20 zu verbinden, um dort einen künstlich erzeugten TE-Impuls einzuleiten und darauf beruhend eine Referenzausbreitungszeit $t_{ref}$ für leitungsgebunden durch das gesamte Betriebsmittel 20 geleitete Ladungsimpulse zu erfassen.

## Patentansprüche

1. Vorrichtung (10) zum Lokalisieren einer Teilentladung in einem Mittel- oder Hochspannungsbetriebsmittel (20), umfassend

   eine Signalerfassungseinrichtung (101) zum Erfassen (301) einer elektrischen Signalgröße des Betriebsmittels (20);
   eine Filtereinrichtung (102) zum Tiefpassfiltern (302) der erfassten elektrischen Signalgröße in Abhängigkeit von einer Filtergrenzfrequenz (fc);
   eine Zeiterfassungseinrichtung (104) zum Erfassen (304) einer Signalausbreitungszeit (t) der tiefpassgefilterten elektrischen Signalgröße; und
   eine Vergleichseinrichtung (105) zum Vergleichen (305) der in Abhängigkeit von der Filtergrenzfrequenz (fc) erfassten Signalausbreitungszeit (t) mit einer Referenzausbreitungszeit ($t_{ref}$) für einen durch das Betriebsmittel (20) geleiteten Ladungsimpuls, um in Abhängigkeit von dem Vergleichsergebnis einen Ort der Teilentladung in dem Betriebsmittel zu bestimmen, **dadurch gekennzeichnet, dass** die Filtereinrichtung (102) zum von einer anfänglichen Filtergrenzfrequenz ($f_{C,0}$) ausgehenden, schrittweisen Reduzieren (303) der Filtergrenzfrequenz (fc) eingerichtet ist, bis eine bei der reduzierten Filtergrenzfrequenz (fc) erfasste Signalausbreitungszeit (t) einen vorgegebenen absoluten Signalausbreitungszeitschwellwert ($t_{th}$) übersteigt oder eine bei der anfänglichen Filtergrenzfrequenz ($f_{C,0}$) erfasste Signalausbreitungszeitdauer ($t_0$) um ein vorgegebenes relatives Signalausbreitungszeitverhältnis (N) übersteigt.

2. Vorrichtung (10) nach Anspruch 1, wobei eine Schrittweite beim Reduzieren der Filtergrenzfrequenz (fc) mindestens 10 kHz beträgt.

3. Vorrichtung (10) nach Anspruch 1 oder Anspruch 2, wobei das vorgegebene relative Signalausbreitungszeitverhältnis (N) mindestens 10 beträgt.

4. Vorrichtung (10) nach einem der vorhergehenden Ansprüche, wobei die Filtergrenzfrequenz (fc) höchstens 1 MHz, bevorzugt höchstens 100 kHz, und weiter bevorzugt höchstens 50 kHz beträgt.

**5.** Vorrichtung (10) nach einem der vorhergehenden Ansprüche, ferner umfassend einen Ladungskalibrator (106) zum leitungsgebundenen Leiten (306) eines Ladungsimpulses durch das Betriebsmittel (20) zum Bestimmen der Referenzausbreitungszeit ($t_{ref}$).

**6.** Vorrichtung (10) nach einem der vorhergehenden Ansprüche, wobei die erfasste elektrische Signalgröße digitale Spannungswerte umfasst, und wobei die Signalerfassungseinrichtung (101) einen digitale Spannungswerte bereitstellenden Spannungsmesser umfasst.

**7.** Vorrichtung (10) nach einem der vorhergehenden Ansprüche, wobei die Filtereinrichtung (102) ein digitales Tiefpassfilter umfasst.

**8.** Vorrichtung (10) nach einem der vorhergehenden Ansprüche, wobei die Zeiterfassungseinrichtung (103) einen digitale Zeitwerte bereitstellenden Zeitmesser umfasst.

**9.** Vorrichtung (10) nach einem der vorhergehenden Ansprüche, wobei die Vergleichseinrichtung (105) eine ein Vergleichsergebnis der erfassten Signalausbreitungszeit (t) mit der Referenzausbreitungszeit ($t_{ref}$) bereitstellende Arithmetikeinheit umfasst.

**10.** Verfahren (30) zum Lokalisieren einer Teilentladung in einem Mittel- oder Hochspannungsbetriebsmittel (20), umfassend

Erfassen (301) einer elektrischen Signalgröße des Betriebsmittels (20); Tiefpassfiltern (302) der erfassten elektrischen Signalgröße in Abhängigkeit von einer Filtergrenzfrequenz (fc); Erfassen (304) einer Signalausbreitungszeit (t) der tiefpassgefilterten elektrischen Signalgröße; und Vergleichen (305) der in Abhängigkeit von der Filtergrenzfrequenz (fc) erfassten Signalausbreitungszeit (t) mit einer Referenzausbreitungszeit ($t_{ref}$) für einen durch das Betriebsmittel (20) geleiteten Ladungsimpuls, um in Abhängigkeit von dem Vergleichsergebnis einen Ort der Teilentladung in dem Betriebsmittel zu bestimmen, **gekennzeichnet durch** von einer anfänglichen Filtergrenzfrequenz ($f_{C,0}$) ausgehendes, schrittweises Reduzieren (303) der Filtergrenzfrequenz (fc), bis eine bei der reduzierten Filtergrenzfrequenz (fc) erfasste Signalausbreitungszeit (t) einen vorgegebenen absoluten Signalausbreitungszeitschwellwert ($t_{th}$) übersteigt oder eine bei der anfänglichen Filtergrenzfrequenz ($f_{C,0}$) erfasste Signalausbreitungszeitdauer ($t_0$) um ein vorgegebenes

relatives Signalausbreitungszeitverhältnis (N) übersteigt.

**11.** Verfahren (30) nach Anspruch 10, ferner umfassend:
leitungsgebundenes Leiten (306) eines Ladungsimpulses durch das Betriebsmittel (20) zum Bestimmen der Referenzausbreitungszeit ($t_{ref}$) auf Grundlage einer Laufzeit des Ladungsimpulses durch das Betriebsmittel vor Lokalisierung der Teilentladung.

**12.** Verfahren (30) nach Anspruch 10 oder Anspruch 11, ferner umfassend:

Bestimmen eines Frequenzbereichs der elektrischen Signalgröße, in dem eine niederfrequente Komponente der Teilentladung gegenüber einer hochfrequenten Komponente der Teilentladung dominiert; und
Erfassen (304) der Signalausbreitungszeit (t) der elektrischen Signalgröße in dem bestimmten Frequenzbereich.

**13.** Verfahren (30) nach einem der Ansprüche 10 - 12, wobei das Verfahren (30) mit der Vorrichtung (10) nach einem der Ansprüche 1 - 9 durchgeführt wird.

**Claims**

**1.** An apparatus (10) for locating a partial discharge in a medium- or high-voltage operating means (20), comprising

a signal detection device (101) for detecting (301) an electrical signal variable of the operating means (20);
a filter device (102) for low-pass filtering (302) of the detected electrical signal variable depending on a filter cut-off frequency (fc);
a time detection device (104) for detecting (304) a signal propagation time (t) of the low-passfiltered electrical signal variable; and
a comparison device (105) for comparing (305) the detected signal propagation time (t) detected depending on the filter cut-off frequency (fc) with a reference propagation time ($t_{ref}$) for a charge pulse conducted through the operating means (20) in order to determine a location of the partial discharge in the operating means depending on the result of the comparison, **characterized in that** the filter device (102) is set up for stepwise reducing (303) the filter cut-off frequency (fc) starting from an initial filter cut-off frequency ($f_{C,0}$) until a signal propagation time (t) detected at the reduced filter cut-off frequency (fc) exceeds a predefined absolute signal propagation

time threshold value ($t_{th}$) or exceeds a signal propagation time period ($t_0$) detected at the initial filter cut-off frequency ($f_{C,0}$) by a predefined relative signal propagation time ratio (N).

2. The apparatus (10) of claim 1, wherein a step size when reducing the filter cut-off frequency (fc) is at least 10 kHz.

3. The apparatus (10) of claim 1 or claim 2, wherein the predefined relative signal propagation time ratio (N) is at least 10.

4. The apparatus (10) of any one of the preceding claims, wherein the filter cut-off frequency (fc) is at most 1 MHz, preferably at most 100 kHz, and more preferably at most 50 kHz.

5. The apparatus (10) of any one of the preceding claims, further comprising a charge calibrator (106) for wired conduction (306) of a charge pulse through the operating means (20) for determining the reference propagation time ($t_{ref}$).

6. The apparatus (10) of any one of the preceding claims, wherein the detected electrical signal variable comprises digital voltage values, and wherein the signal detection device (101) comprises a voltmeter that provides digital voltage values.

7. The apparatus (10) of any one of the preceding claims, wherein the filter device (102) comprises a digital low-pass filter.

8. The apparatus (10) of any one of the preceding claims, wherein the time detection device (103) comprises a timer that provides digital time values.

9. The apparatus (10) of any one of the preceding claims, wherein the comparison device (105) comprises an arithmetic unit that provides a comparison result of the detected signal propagation time (t) with the reference propagation time (tref).

10. A method (30) for locating a partial discharge in a medium- or high-voltage operating means (20), comprising

    detecting (301) an electrical signal variable of the operating means (20); low-pass filtering (302) of the detected electrical signal variable depending on a filter cut-off frequency (fc); detecting (304) a signal propagation time (t) of the low-pass-filtered electrical signal variable; and comparing (305) the detected signal propagation time (t) detected depending on the filter cut-off frequency (fc) with a reference propagation time ($t_{ref}$) for a charge pulse conducted through the operating means (20) in order to determine a location of the partial discharge in the operating means depending on the result of the comparison,

**characterized by**
stepwise reducing (303) the filter cut-off frequency (fc) starting from an initial filter cut-off frequency ($f_{C,0}$) until a signal propagation time (t) detected at the reduced filter cut-off frequency (fc) exceeds a predefined absolute signal propagation time threshold value ($t_{th}$) or exceeds a signal propagation period ($t_0$) detected at the initial filter cut-off frequency ($f_{C,0}$) by a predefined relative signal propagation time ratio (N).

11. The method (30) of claim 10, further comprising:
wired conducting (306) of a charge pulse through the operating means (20) for determining the reference propagation time ($t_{ref}$) based on a running time of the charge pulse through the operating means before locating the partial discharge.

12. The method (30) of claim 10 or claim 11, further comprising:

    determining a frequency range of the electrical signal variable in which a low-frequency component of the partial discharge dominates over a highfrequency component of the partial discharge; and
detecting (304) the signal propagation time (t) of the electrical signal variable in the determined frequency range.

13. The method (30) of any one of claims 10-12, wherein the method (30) is carried out using the apparatus (10) of any one of claims 1-9.

**Revendications**

1. Dispositif (10) permettant de localiser une décharge partielle dans un moyen de production à moyenne ou haute tension (20), comprenant

    un appareil de détection de signal (101) permettant de détecter (301) une grandeur de signal électrique du moyen de production (20) ;
un appareil de filtrage (102) pour le filtrage passe-bas (302) de la grandeur de signal électrique détectée en fonction d'une fréquence limite de filtrage (fc) ;
un appareil de détection de temps (104) permettant de détecter (304) un temps de propagation de signal (t) de la grandeur de signal électrique filtrée par filtre passe-bas ; et

un appareil de comparaison (105) permettant de comparer (305) le temps de propagation de signal (t) détecté en fonction de la fréquence limite de filtrage (fc) avec un temps de propagation de référence ($t_{ref}$) pour une impulsion de charge conduite à travers le moyen de production (20) afin de déterminer, en fonction du résultat de la comparaison, un emplacement de la décharge partielle dans le moyen de production, **caractérisé en ce que** l'appareil de filtrage (102) est configuré pour réduire (303) pas à pas la fréquence limite de filtrage (fc) en partant d'une fréquence limite de filtrage initiale ($f_{C,0}$), jusqu'à ce qu'un temps de propagation de signal (t) détecté à la fréquence limite de filtrage (fc) réduite dépasse une valeur seuil de temps de propagation de signal absolue prédéfinie ($t_{th}$) ou dépasse une durée de temps de propagation de signal ($t_0$) détectée à la fréquence limite de filtrage initiale ($f_{C,0}$) d'un rapport de temps de propagation de signal relatif prédéfini (N).

2. Dispositif (10) selon la revendication 1, dans lequel une largeur de pas lors de la réduction de la fréquence limite de filtrage (fc) est d'au moins 10 kHz.

3. Dispositif (10) selon la revendication 1 ou la revendication 2, dans lequel le rapport de temps de propagation de signal relatif prédéfini (N) est d'au moins 10.

4. Dispositif (10) selon l'une des revendications précédentes, dans lequel la fréquence limite de filtrage (fc) est au plus de 1 MHz, de préférence au plus de 100 kHz, et encore plus préférablement au plus de 50 kHz.

5. Dispositif (10) selon l'une des revendications précédentes, comprenant en outre un calibrateur de charge (106) permettant de conduire (306) par conduction une impulsion de charge à travers le moyen de production (20) pour la détermination du temps de propagation de référence ($t_{ref}$).

6. Dispositif (10) selon l'une des revendications précédentes, dans lequel la grandeur de signal électrique détectée comprend des valeurs de tension numériques, et dans lequel l'appareil de détection de signal (101) comprend un voltmètre fournissant des valeurs de tension numériques.

7. Dispositif (10) selon l'une des revendications précédentes, dans lequel l'appareil de filtrage (102) comprend un filtre passe-bas numérique.

8. Dispositif (10) selon l'une des revendications précédentes, dans lequel l'appareil de détection de temps (103) comprend un chronomètre fournissant des valeurs de temps numériques.

9. Dispositif (10) selon l'une des revendications précédentes, dans lequel l'appareil de comparaison (105) comprend une unité arithmétique fournissant un résultat de comparaison du temps de propagation de signal (t) détecté avec le temps de propagation de référence ($t_{ref}$).

10. Procédé (30) permettant de localiser une décharge partielle dans un moyen de production à moyenne ou haute tension (20), comprenant

la détection (301) d'une grandeur de signal électrique du moyen de production (20) ;
le filtrage par filtre passe-bas (302) de la grandeur de signal électrique détectée en fonction d'une fréquence limite de filtrage (fc) ;
la détection (304) d'un temps de propagation de signal (t) de la grandeur de signal électrique filtrée par filtre passe-bas ; et
la comparaison (305) du temps de propagation de signal (t) détecté en fonction de la fréquence limite de filtrage (fc) avec un temps de propagation de référence ($t_{ref}$) pour une impulsion de charge conduite à travers le moyen de production (20) afin de déterminer, en fonction du résultat de la comparaison, un emplacement de la décharge partielle dans le moyen de production, **caractérisé par** la réduction (303) pas à pas de la fréquence limite de filtrage (fc) en partant d'une fréquence limite de filtrage initiale ($f_{C,0}$), jusqu'à ce qu'un temps de propagation de signal (t) détecté à la fréquence limite de filtrage (fc) réduite dépasse une valeur seuil de temps de propagation de signal absolue prédéfinie ($t_{th}$) ou dépasse une durée de temps de propagation de signal ($t_0$) détectée à la fréquence limite de filtrage initiale ($f_{C,0}$) d'un rapport de temps de propagation de signal relatif prédéfini (N).

11. Procédé (30) selon la revendication 10, comprenant en outre :
le fait de conduire (306) par conduction une impulsion de charge à travers le moyen de production (20) pour la détermination du temps de propagation de référence ($t_{ref}$) sur la base d'un temps de propagation de l'impulsion de charge à travers le moyen de production avant la localisation de la décharge partielle.

12. Procédé (30) selon la revendication 10 ou la revendication 11, comprenant en outre :

la détermination d'une plage de fréquences de la grandeur de signal électrique dans laquelle une composante à basse fréquence de la décharge partielle domine une composante à haute fréquence de la décharge partielle ; et la détection (304) du temps de propagation de signal (t) de la grandeur de signal électrique dans la plage de fréquences déterminée.

13. Procédé (30) selon l'une des revendications 10 à 12, dans lequel le procédé (30) est mis en oeuvre par le dispositif (10) selon l'une des revendications 1 à 9.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2360486 A1

**In der Beschreibung aufgeführte Nicht-Patentliteratur**

- **LUO YUANLIN et al.** A Review of Online Partial Discharge Measurement of Large Generators. *ENERGIES*, 25 October 2017, vol. 10 (11), 1694